(19) Europäisches Patentamt
European Patent Office
Office européen des brevets

(11) **EP 2 795 354 B1**

(12) **FASCICULE DE BREVET EUROPEEN**

(45) Date de publication et mention
de la délivrance du brevet:
**09.03.2016 Bulletin 2016/10**

(21) Numéro de dépôt: **12801568.2**

(22) Date de dépôt: **13.12.2012**

(51) Int Cl.:
***G01R 33/26*** (2006.01)     *G02F 1/13363* (2006.01)

(86) Numéro de dépôt international:
**PCT/EP2012/075426**

(87) Numéro de publication internationale:
**WO 2013/092383 (27.06.2013 Gazette 2013/26)**

(54) **MAGNÉTOMÈTRE À POMPAGE OPTIQUE INTÉGRÉ ET ISOTROPE**

ISOTROPES MAGNETOMETER MIT INTEGRIERTEM OPTISCHEM PUMPEN

ISOTROPIC AND INTEGRATED OPTICAL PUMPING MAGNETOMETER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **19.12.2011 FR 1161946**

(43) Date de publication de la demande:
**29.10.2014 Bulletin 2014/44**

(73) Titulaire: **Commissariat à l'Énergie Atomique
et aux Énergies Alternatives
75015 Paris (FR)**

(72) Inventeurs:
• **MORALES, Sophie**
  **F-38760 Varces (FR)**
• **CLERC, Laurence**
  **F-38320 Brie Et Angonnes (FR)**
• **FOURCAULT, William**
  **F-38000 Grenoble (FR)**
• **LE PRADO, Matthieu**
  **F-38160 Saint Marcellin (FR)**
• **LEGER, Jean-Michel**
  **F-38190 Villard Bonnot (FR)**
• **ROSSINI, Umberto**
  **F-38500 Coublevie (FR)**
• **RUTKOWSKI, Jaroslaw**
  **PL-50-555 Wroclaw (PL)**

(74) Mandataire: **Brevalex
95, rue d'Amsterdam
75378 Paris Cedex 8 (FR)**

(56) Documents cités:
**EP-A1- 0 462 002     EP-A1- 0 579 537
EP-A1- 0 964 260**

• **MORENO I ET AL: "TWO-DIMENSIONAL
POLARIZATION ROTATOR USING A
TWISTED-NEMATIC LIQUID-CRYSTAL
DISPLAY", APPLIED OPTICS, OPTICAL SOCIETY
OF AMERICA, WASHINGTON, DC; US, vol. 46, no.
6, 20 février 2007 (2007-02-20), pages 881-887,
XP001504658, ISSN: 0003-6935, DOI:
10.1364/AO.46.000881**

## Description

## DOMAINE TECHNIQUE

La présente invention concerne le domaine des magnétomètres à pompage optique.

## ÉTAT DE LA TECHNIQUE ANTÉRIEURE

Les magnétomètres à pompage optique sont connus depuis plusieurs décennies. Ils sont basés sur la résonance magnétique entre raies Zeeman, amplifiée à l'aide d'un pompage optique. Par exemple dans un magnétomètre de ce type utilisant une cellule d'hélium ($^4$He) les atomes d'hélium au niveau $1^1S_0$ sont excités au niveau métastable $2^3S_1$ au moyen d'une décharge HF. Ce niveau métastable $2^3S_1$ est divisé en un triplet Zeeman en présence d'un champ magnétique statique. Les atomes du niveau $2^3S_1$ sont pompés optiquement vers le niveau $2^3P_0$ à l'aide d'un laser accordable. Il en résulte une déplétion différente des différentes raies du triplet, par excitation sélective au niveau $2^3P_0$. Les atomes ainsi excités retournent par émission spontanée au niveau métastable $2^3S_1$. On induit une résonance magnétique entre les niveaux du triplet au moyen d'un champ RF à la fréquence de Larmor. L'amplitude du signal de résonance est amplifiée par le pompage optique. La résonance est observée au moyen d'un pic d'absorption en sortie de la cellule. En pratique, le générateur du champ RF est asservi en fréquence sur le pic d'absorption au moyen d'une boucle PLL, et le module du champ magnétique se déduit directement de la fréquence de résonance $F$ à partir de la relation de Larmor $B_0 = (2\pi/\gamma)F$ où $\gamma$ est le rapport gyromagnétique de l'électron. Un tel magnétomètre mesurant le module du champ magnétique est encore appelé magnétomètre scalaire dans la littérature.

On trouvera une description détaillée d'un magnétomètre à pompage optique dans la demande EP-A-579 537. Un tel magnétomètre est illustré en Fig. 1.

Il comprend une cellule 10 emplie d'hélium, un laser 14 émettant un faisceau 15, à une longueur d'onde accordée à la différence d'énergie entre les niveaux $2^3P_0$ et $2^3S_1$ de $^4$He, un polariseur 16 ayant une polarisation rectiligne **P,** un photodétecteur 24 recevant le faisceau 18 ayant traversé la cellule, un asservissement de fréquence contrôlant un générateur de fréquence RF 22, un estimateur de fréquence 26 et un circuit de décharge HF 30.

Le circuit de décharge 30 fait passer les atomes d'hélium du niveau fondamental $1^1S_0$ au niveau métastable $2^3S_1$ au moyen d'une décharge électrostatique haute fréquence entre deux électrodes placées sur la cellule.

Le générateur de fréquence RF alimente en courant deux bobines $56_1$ et $56_2$, d'axes orthogonaux, entourant la cellule 10 de manière à engendrer un champ magnétique radiofréquence au sein de cette dernière.

Les axes des deux bobines et la direction de propagation du faisceau forment un trièdre rectangle. Le champ magnétique RF généré par les bobines induit une résonance entre les niveaux du triplet Zeeman.

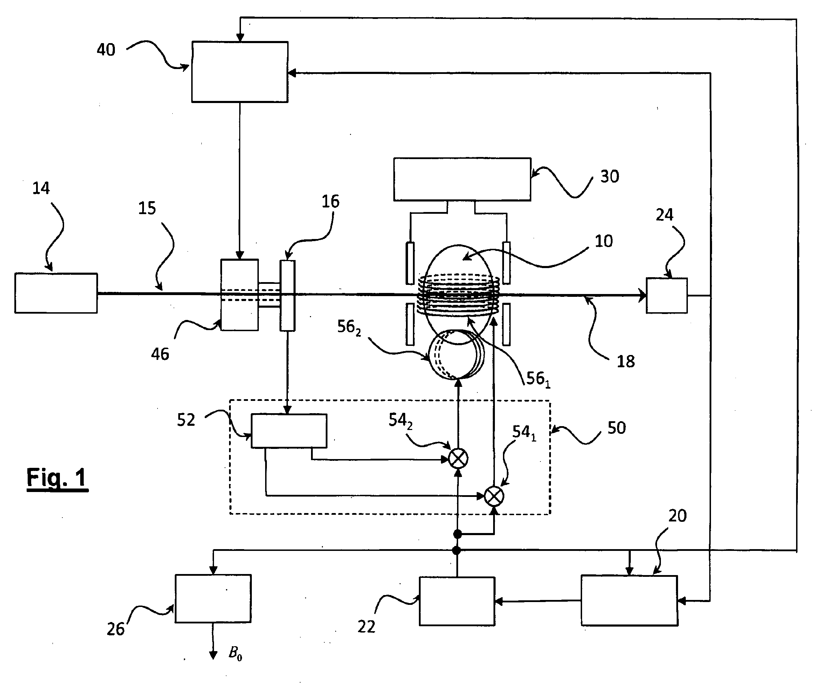

Le magnétomètre comprend un premier circuit d'asservissement en fréquence, 20, (sur la fréquence de Larmor), un second circuit d'asservissement, 40, commandant la direction de polarisation du polariseur 16 et un troisième circuit d'asservissement 50 commandant la direction du champ magnétique radiofréquence. L'asservissement en fréquence du magnétomètre peut être réalisé à partir de la composante continue $LA_0$ du signal A en sortie du photodétecteur ou à partir de la composante $LA_2$ (comme représenté en Fig. 1), à la fréquence double de la fréquence de Larmor.

Plus précisément, le second circuit d'asservissement 40 contrôle un moteur 46 réglant la position angulaire $\varphi$ du polariseur 16 et donc la direction de polarisation **P** de manière à obtenir l'amplitude maximale du signal de résonance. On peut montrer que si $\theta$ est l'angle entre la direction de polarisation et celle du champ magnétique ambiant, $\mathbf{B_0}$, la composante continue $LA_0$ du signal A en sortie du photodétecteur évolue en $(3\cos^2\theta-1)^2$. Elle est donc d'amplitude maximale pour $\theta = 0°$ et $\theta = 90°$. En général, la valeur $\theta = 0°$ ne peut être atteinte en faisant varier la position angulaire du polariseur (elle ne le peut que si $\mathbf{B_0}$ est situé dans le plan du polariseur). En revanche, la valeur $\theta = 90°$ peut toujours être atteinte pour une valeur $\varphi_{max}$ de la position angulaire du polariseur. La composante $LA_1^Q$ du signal A en quadrature de phase avec le signal radiofréquence s'annule pour $\theta = 90°$ et sert de signal d'erreur au circuit d'asservissement 40. Ce circuit asservit donc la position angulaire du polariseur à la valeur $\varphi_{max}$.

Le troisième circuit d'asservissement 50 comprend un détecteur d'angle de polarisation 52 délivrant deux signaux proportionnels à $\cos\varphi$ et $\sin\varphi$, ainsi que deux multiplieurs $54_1$ et $54_2$ multipliant respectivement ces deux signaux avec le signal RF. Les signaux produits alimentent respectivement les bobines $56_1$ et $56_2$ de sorte que le champ magnétique RF, $\mathbf{B_{RF}}$, ait toujours la même direction que la polarisation **P** du faisceau.

Les circuits d'asservissement 40 et 50 maintiennent donc en permanence l'orthogonalité entre la polarisation **P** et le champ magnétique ambiant $\mathbf{B_0}$, d'une part et l'alignement du champ magnétique $\mathbf{B_{RF}}$ sur la polarisation **P,** d'autre part.

Dans cette configuration, les conditions de la détection de la résonance sont optimales et ne dépendent pas de l'orientation relative du magnétomètre par rapport au champ $\mathbf{B_0}$. Un tel magnétomètre est qualifié pour cette raison d'isotrope.

L'utilisation d'un polariseur motorisé en rotation dans un magnétomètre présente toutefois des inconvénients.

Tout d'abord, le moteur doit être amagnétique au sens où il ne doit pas perturber le champ magnétique ambiant, ce d'autant que le polariseur doit être placé de préférence à proximité de la cellule.

Ensuite, la rotation du moteur génère des micro-vibrations et des variations de couplage optique qui peuvent elles-mêmes perturber la mesure.

Enfin, ce mécanisme est fragile et susceptible de se dérégler dans le temps (désalignement optique notamment). Il se prête mal à une intégration et une miniaturisation.

Le but de la présente invention est par conséquent de proposer un magnétomètre à pompage optique, isotrope, qui ne présente pas les inconvénients précités et qui se prête bien à une intégration, par exemple pour une application embarquée ou spatiale.

## EXPOSÉ DE L'INVENTION

La présente invention est définie par le magnétomètre à pompage optique de la revendication 1 qui a été délimité par rapport à celui de la demande EP-A-579 537. Des modes de réalisation avantageux sont définis dans les revendications dépendantes 2 à 12.

## BRÈVE DESCRIPTION DES DESSINS

La Fig. 1 représente de manière schématique un magnétomètre à pompage optique connu de l'état de la technique ;

La Fig. 2 représente de manière schématique un magnétomètre à pompage optique selon un mode de réalisation de l'invention ;

La Fig. 3A représente un premier exemple de réalisation d'un rotateur de polarisation utilisé dans le magnétomètre de la Fig. 2 ;

La Fig. 3B illustre le principe du rotateur de polarisation de la Fig. 3A sur la sphère de Poincaré ;

La Fig. 3C représente un exemple de courbe de calibration pour le rotateur de polarisation de la Fig. 3A;

La Fig. 4 représente un second exemple de réalisation d'un rotateur de polarisation utilisé dans le magnétomètre de la Fig. 2 ;

La Fig. 5 représente un troisième exemple de réalisation d'un rotateur de polarisation utilisé dans le magnétomètre de la Fig. 2 ;

La Fig. 6 représente un exemple de réalisation intégrée du magnétomètre de la Fig. 2.

## EXPOSÉ DÉTAILLÉ DE MODES DE RÉALISATION PARTICULIERS

Le principe de base de l'invention est d'utiliser un rotateur de polarisation à cristal liquide en lieu et place du polariseur motorisé de l'art antérieur.

De manière générale, un rotateur de polarisation permet de faire tourner la direction de polarisation d'une onde polarisée rectilignement.

Un rotateur de polarisation à cristal liquide ne comporte pas d'élément mécanique mobile et présente une faible signature magnétique (au sens où il perturbe peu le champ magnétique ambiant). Il est également susceptible de pouvoir être intégré dans une structure compacte comme nous le verrons plus loin

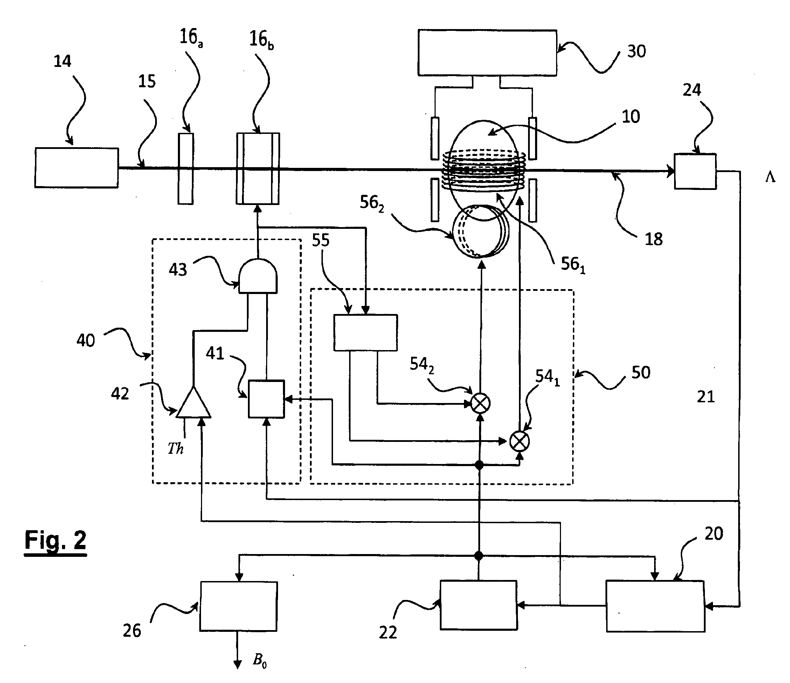

La Fig. 2 représente un magnétomètre à pompage optique selon un mode de réalisation de l'invention.

Le principe de la mesure du module de champ magnétique est le même que celui exposé en relation avec la Fig. 1. Les éléments identiques ou similaires à ceux de la Fig. 1 portent les mêmes signes de référence.

Plus précisément, le magnétomètre en Fig. 2 comprend un laser 14, un polariseur rectiligne optionnel 16a, un rotateur de polarisation à cristal liquide 16b, une cellule 10 emplie de gaz, en général de l'hélium ou un gaz alcalin, un photodétecteur 24 recevant le faisceau 18 ayant traversé la cellule, un premier circuit d'asservissement de fréquence 20 contrôlant un générateur de fréquence RF 22, un estimateur de fréquence 26 et un circuit de décharge HF 30. Le générateur de fréquence RF alimente en courant deux bobines $56_1$ et $56_2$, d'axes orthogonaux, entourant la cellule 10, comme précédemment. Les axes des deux bobines et la direction de propagation du faisceau forment un trièdre rectangle.

Le magnétomètre comprend en outre un second circuit d'asservissement 40 commandant la rotation de polarisation du rotateur 16b et un troisième circuit d'asservissement 50 commandant la direction du champ magnétique radiofréquence.

Le second circuit d'asservissement 40 reçoit le signal A issu du photodétecteur et effectue, au moyen du module 41, une détection synchrone à la fréquence RF fournie par le synthétiseur de fréquence 22. La composante en quadrature de phase à cette fréquence, notée $LA_i^Q$, sert de signal d'erreur pour contrôler la tension de commande du rotateur de polarisation. Cette composante en quadrature évolue en $\sin 2\theta(3\cos^2\theta - 1)$ et s'annule par conséquent lorsque l'angle entre **P** et $\mathbf{B_0}$ est soit de 0°, de 90°, soit d'environ 54° $(\cos\theta = 1/\sqrt{3})$, où **P** est la direction de polarisation du faisceau en sortie du rotateur. Pour éviter que l'asservissement ne s'accroche sur les valeurs angulaires 0° et 54°, on utilise avantageusement, en sus de $LA_i^Q$, la composante continue $LA_0$ ou bien la composante à la seconde harmonique de la fréquence RF, $LA_2$. En effet, Les modules des composantes $LA_0$ et $LA_2$ présentent un maximum pour $\theta = 90°$ et s'annulent pour $\theta = 0°$ et $\theta = 54°$. Quelle que soit la composante utilisée, son intensité est comparée à une valeur de seuil $Th$ dans un comparateur 42. Si l'intensité de la composante $LA_0$ (ou $LA_2$) est supérieure à ce seuil, le comparateur valide le signal d'erreur $LA_i^Q$ au moyen de la porte logique 43. Lorsqu'il est validé, le signal d'erreur contrôle la tension appliquée au rotateur de polarisation 16b de manière à ce que la direction de polarisation du faisceau en sortie soit orientée selon l'angle $\varphi_{max}$, c'est-à-dire soit orthogonale à $\mathbf{B_0}$. Cette comparaison à une valeur seuil peut n'être effectuée que lors de la mise en route du magnétomètre, pour accrocher la polarisation à la valeur $\theta = 90°$. Si le champ change ensuite de direction, la polarisation reste asservie sur cette valeur.

La tension issue du signal d'erreur $LA_1^Q$ est également transmise à un module de conversion 55 du troisième circuit d'asservissement 50. Ce module de conversion fournit des signaux proportionnels à $\cos\varphi$ et $\sin\varphi$ à partir de la valeur de la tension en question. On notera que $\varphi = \varphi_0 + \psi$ où $\psi$ est l'angle de rotation de polarisation et $\varphi_0$ est l'angle à imposer lorsque la tension est nulle pour maintenir l'alignement entre le champ magnétique $\mathbf{B_{RF}}$ et la direction de polarisation $\mathbf{P}$. Pour ce faire, il comprend par exemple une mémoire (table de « look-up ») dans laquelle sont stockées des courbes de calibration de l'angle de rotation de la polarisation en fonction de la tension appliquée au rotateur de polarisation. Ces courbes de calibration sont relatives à différentes températures de fonctionnement. Pour une température donnée et une valeur de tension appliquée, la mémoire fournit un couple de valeurs proportionnelles à $\cos\varphi$ et $\sin\varphi$ (ou bien seulement l'angle $\varphi$, le calcul trigonométrique étant fait à l'extérieur). Ces valeurs trigonométriques sont multipliées au moyen des multiplicateurs $54_1$ et $54_2$ avec le signal RF issu du synthétiseur de fréquence 26. Les signaux issus des multiplicateurs $54_1$ et $54_2$ alimentent en courant les bobines d'induction $56_1$ et $56_2$ respectivement. Ainsi le champ magnétique $\mathbf{B_{RF}}$ généré dans la cellule est sensiblement parallèle à la polarisation du faisceau en sortie du rotateur.

On pourra se passer du polariseur 16a à l'entrée du rotateur de polarisation 16b si le faisceau émis par le laser 14 présente déjà une polarisation rectiligne ou un taux d'extinction élevé (compatible avec le pourcentage d'ellipticité maximum acceptable pour un magnétomètre). En général, la direction de polarisation en entrée du rotateur peut être quelconque. Toutefois, comme nous le verrons plus loin, pour certains types de rotateurs, la direction de polarisation en entrée du rotateur peut être fixée par ce dernier.

Le synthétiseur de fréquence (ou l'oscillateur commandé en tension) 22 est piloté par le circuit d'asservissement en fréquence 20. Celui-ci utilise un signal d'erreur généré par un module de détection synchrone. Ce module effectue une détection synchrone du signal A issu du photodétecteur à une fréquence de référence et fournit en sortie soit la composante continue $LA_0$ soit le module du signal de résonance $LA_2$ au double de la fréquence de Larmor. L'asservissement en fréquence peut être obtenu indifféremment à partir de l'une ou l'autre de ces composantes. A la résonance, la fréquence RF, F est calée sur la fréquence de Larmor

$$f_{Larmor} = \frac{\gamma}{2\pi} B_0.$$

L'intensité du champ magnétique ambiant, $B_0$, est donnée, au rapport gyromagnétique près, par un estimateur de fréquence 26 estimant directement la fréquence F du signal en sortie du synthétiseur 22 voire, indirectement, à partir du signal de commande de ce dernier.

Enfin, le magnétomètre pourra comporter des moyens d'asservissement en longueur d'onde du laser, de manière connue en soi.

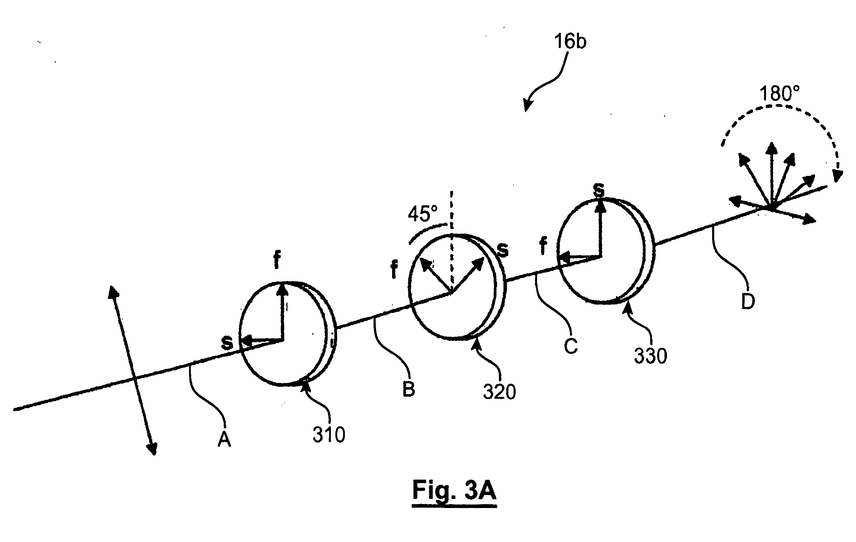

La Fig. 3A représente un premier exemple de rotateur de polarisation 16b pouvant être utilisé dans un magnétomètre à pompage optique selon l'invention.

Le rotateur de polarisation comprend une première lame quart d'onde 310, une lame à retard variable à cristaux liquides 320 et une seconde lame quart d'onde 330. Ces différents éléments sont réalisés en un matériau biréfringent et pour chaque élément on a désigné par $s$ l'axe lent et $f$ l'axe rapide. L'axe rapide de la seconde lame quart d'onde coïncide avec l'axe lent de la première et l'axe lent de la seconde lame quart d'onde coïncide avec l'axe rapide de la première. La bissectrice des lignes neutres (c'est-à-dire des axes lent et rapide, encore dénommés ci-après axes neutres) de la lame à retard variable est orientée de manière à être alignée sur un axe neutre des première et seconde lames quart d'onde. En pratique, l'alignement entre les deux lames quart d'onde, d'une part, et entre chacune des lames quart d'onde et la lame à retard variable, d'autre part, devra être réalisée au degré près.

On rappelle qu'en incidence normale, une lame quart d'onde transforme une onde incidente à polarisation rectiligne en une onde à polarisation elliptique dont les axes sont les axes neutres de cette lame.

Du fait de son orientation bissectrice, la lame à retard variable modifie l'ellipticité de cette polarisation sans modifier la direction de ses axes propres.

La seconde lame quart d'onde transforme l'onde polarisée elliptiquement issue de la lame à retard 320 en une onde de sortie polarisée rectilignement puisque les axes propres de la polarisation coïncident avec ses axes neutres.

Ainsi, l'onde de sortie présente une polarisation rectiligne orientée selon une direction tournée par rapport à la direction de polarisation de l'onde incidente.

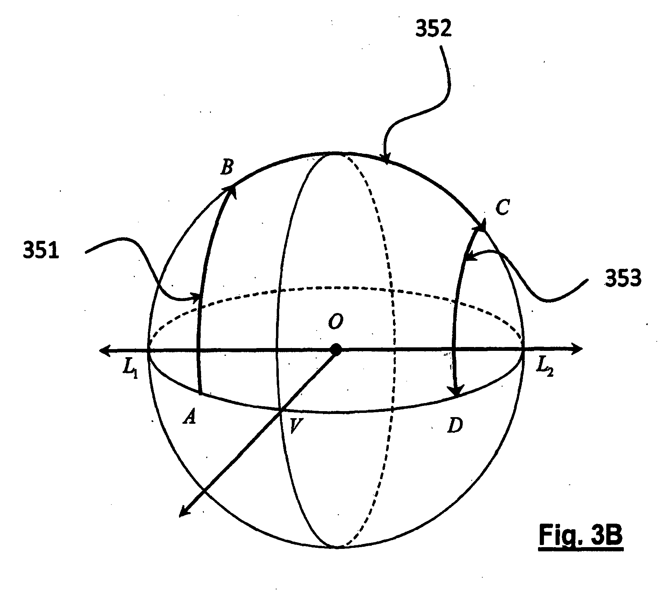

Le principe du rotateur de polarisation sera mieux compris à l'aide de la sphère de Poincaré illustrée en Fig. 3B.

On rappelle que l'équateur de la sphère de Poincaré représente les polarisations rectilignes et les pôles les polarisations circulaires (droite et gauche). Tous les autres points de la sphère correspondent à des polarisations elliptiques. Lorsque l'on parcourt un méridien de la sphère, les axes propres de la polarisation restent inchangés, seule l'ellipticité varie.

L'effet d'un élément biréfringent sur une polarisation se traduit sur la sphère de Poincaré par une rotation autour d'un axe reliant deux points diamétralement opposés de la sphère, chacun représentant une polarisation rectiligne selon une ligne neutre (ou axe neutre) de l'élément en question. L'axe de rotation est noté $OL_1$ pour la première lame quart d'onde, OV pour la lame à retard variable et $OL_2$ pour la seconde lame quart d'onde. On notera que, du fait de l'orientation de la lame à retard en Fig. 3A, la droite OV est orthogonale à la droite $L_1L_2$.

On a représenté sur la sphère la polarisation de l'onde incidente par le point A. Cette polarisation peut être ici de direction quelconque (le point A est situé en un point quelconque de l'équateur). Le point B correspond à la polarisation en sortie de la première lame quart d'onde. Il se déduit de A par une rotation autour de l'axe $OL_1$ (arc de cercle 351). Le point C correspond à la polarisation en sortie de la lame à retard variable 320. Il se déduit du point B par une rotation autour de l'axe OV (arc de cercle 352). L'angle de rotation (ou la longueur de l'arc de méridien) est fonction du retard introduit par la lame 320. Enfin, le point D correspond à la polarisation en sortie de la seconde lame quart d'onde. Il se déduit du point C par une rotation autour de l'axe $OL_2$. On notera que l'angle entre les droites OA et OD est égal au double de l'angle de rotation $\alpha$ de la polarisation induite par le rotateur.

La lame à retard variable est constituée d'une cellule de cristal liquide nématique avec ancrage homogène (cellule à l'état ON au repos) ou homéotrope (cellule à l'état OFF au repos), avec la convention qu'à l'état OFF, la cellule de cristal liquide n'effectue pas de rotation de polarisation.

Le cristal liquide est avantageusement un cristal liquide nématique amagnétique. On pourra notamment utiliser à cet effet le cristal liquide commercialisé par la firme Merck™ sous la référence MLC2062. Ce cristal liquide est en outre caractérisé par une forte biréfringence et une faible viscosité. Alternativement, on pourra utiliser le cristal liquide commercialisé par la firme DIC sous la référence 9BD-25.

De manière générale, le choix du cristal liquide résultera d'un compromis entre épaisseur, biréfringence (écart entre l'indice rapide et l'indice lent du cristal liquide) et temps de réponse, comme expliqué ci-après.

Le retard induit par la lame à retard, et donc la rotation de polarisation, est fonction de la tension appliquée à la cellule de cristal liquide, de l'épaisseur de cette couche et de la température de fonctionnement.

L'angle maximum de rotation de la polarisation est proportionnel à l'épaisseur de la couche de cristal liquide. Pour obtenir un magnétomètre isotrope, il est nécessaire que cet angle maximum soit au moins de 180°. Ainsi est-on certain de pouvoir rendre la polarisation **P** orthogonale à $\mathbf{B}_0$.

En pratique, l'épaisseur de la couche de cristal liquide peut résulter d'un compromis entre l'angle maximum de rotation de la polarisation et de son temps de réponse. En effet, le temps de réponse de la couche de cristal liquide (et donc du magnétomètre) est proportionnel au carré de son épaisseur. A titre d'exemple, l'épaisseur de la couche de cristal liquide sera comprise entre 5 $\mu$m entre 10 $\mu$m pour du MLC2062.

La biréfringence du cristal liquide dépend de la température de fonctionnement. A chaque température de fonctionnement correspond une courbe de calibration donnant l'angle de rotation de la polarisation en fonction de la tension appliquée.

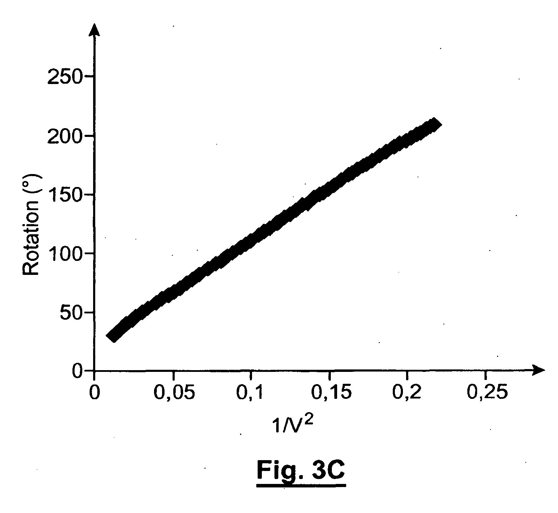

La Fig. 3C donne un exemple de courbe de calibration pour une cellule de cristal liquide MLC2062 de 10 $\mu$m d'épaisseur à une température de 20°C.

On constate que la rotation de polarisation est, en première approximation, inversement proportionnelle au carré de la tension appliquée. A chaque température correspond un coefficient de proportionnalité différent. Le rotateur de polarisation est calibré pour une plage de température de fonctionnement allant par exemple de 10°C à 50°C, chaque courbe de calibration (ou chaque coefficient de proportionnalité) servant à calculer les données stockées dans la mémoire du module de conversion 55.

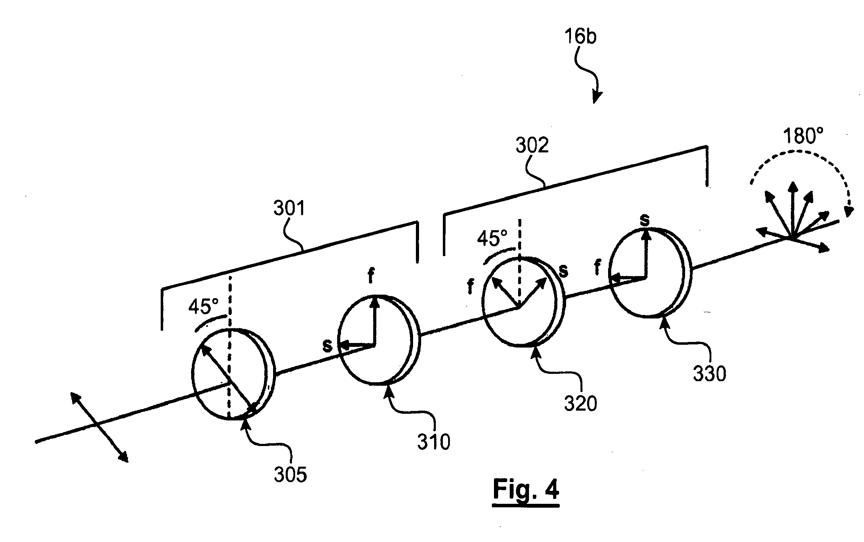

La Fig. 4 représente un second exemple de réalisation d'un rotateur de polarisation pouvant être utilisé dans un magnétomètre à pompage optique selon l'invention.

Ce rotateur se distingue de celui de la Fig. 3 par la présence d'un polariseur d'entrée 305 en amont de la première lame quart d'onde 310. Il suppose que l'onde incidente ait une polarisation rectiligne coïncidant avec celle du polariseur 305. Par exemple le laser 14 fournit directement une onde polarisée linéairement dans cette direction et le polariseur 16a est absent.

La direction de polarisation du polariseur 305 est orientée de sorte à coïncider avec la bissectrice des axes neutres de la première lame quart d'onde. Cette configuration présente deux avantages. Tout d'abord, la polarisation en sortie de la première lame quart d'onde étant circulaire, la lame à retard 320 peut être orientée de manière quelconque par rapport à cette dernière (son orientation par rapport à la seconde lame quart d'onde est cependant contrainte par la même condition que précédemment). Ensuite, l'ensemble constitué par le polariseur et la première lame quart d'onde constitue un isolateur optique : une réflexion en aval de la première lame quart d'onde (par exemple sur la face amont de la lame à retard variable 320) se traduit par une onde réfléchie, polarisée circulairement se propageant dans le sens inverse de l'onde incidente, onde réfléchie qui est transformée par cette même lame en une onde de polarisation rectiligne présentant une direction de polarisation orthogonale à celle du polariseur.

Pour le reste, le fonctionnement du rotateur de polarisation est identique au précédent. On notera que sur la sphère de Poincaré, le point A coïncide ici avec le point V et le point B correspond au pôle supérieur.

Dans cet exemple de réalisation, le polariseur d'entrée 305 et la première lame quart d'onde 310 forment un premier bloc optique, 301. De même, la lame à retard variable, 320, et la seconde lame quart d'onde 330 forment un second bloc optique, 302. Par bloc optique, on entend un ensemble d'éléments optiques dont l'orientation relative atour de l'axe optique commun est fixe, par exemple au moyen d'une liaison mécanique entre ces éléments.

On peut montrer qu'un tel rotateur est robuste vis-à-vis d'un désalignement éventuel entre éléments du premier bloc optique (polariseur d'entrée et première lame quart d'onde) ainsi que d'un désalignement entre les premier et second blocs optiques (autrement dit entre les axes neutres des première et seconde lames quart d'onde). Plus précisément, un tel montage à deux blocs optiques n'introduit qu'une faible ellipticité en sortie du rotateur de polarisation : une onde polarisée rectilignement selon la direction de polarisation d'entrée est transformée en une onde polarisée rectilignement, tournée d'un angle $\alpha$.

Le montage à deux blocs optiques 301 et 302 ne requiert pas d'alignement précis sur un banc optique (l'alignement entre les deux blocs optiques est simplement réalisé *in situ*) et est donc particulièrement aisé à mettre en oeuvre.

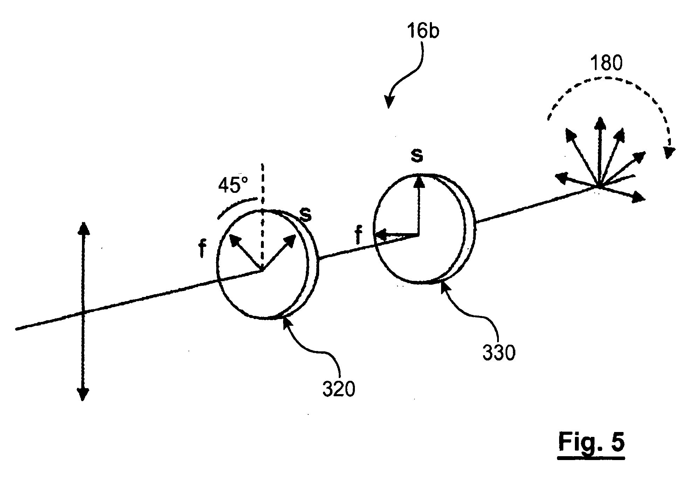

La Fig. 5 représente un troisième exemple de réalisation d'un rotateur de polarisation pouvant être utilisé dans un magnétomètre à pompage optique selon l'invention.

Ce rotateur de polarisation a une structure plus simple que les deux précédents puisque la première lame quart d'onde est supprimée. Il suppose toutefois que la direction de polarisation de l'onde incidente coïncide avec la bissectrice des axes neutres de la lame à retard (ou avec l'orthogonale de cette bissectrice). Cette condition peut être obtenue en faisant tourner le rotateur par rapport au faisceau (s'il est déjà polarisé) ou en plaçant un polariseur 16a convenablement orienté. Dans tous les cas, et comme précédemment, la bissectrice des axes neutres de la lame à retard coïncide avec un axe neutre de la lame quart d'onde de sortie.

Si l'on revient à la sphère de Poincaré de la Fig. 3B, cela revient simplement à considérer le cas où le point A coïncide avec le point $L_1$ (ou $L_2$). On comprend que la première lame quart d'onde est ici superflue puisque la polarisation de l'onde incidente coïnciderait avec un axe neutre de celle-ci. La lame à retard fait accomplir à la polarisation un arc de cercle sur le méridien de la sphère et la lame quart d'onde la ramène sur l'équateur comme précédemment.

On remarquera que le troisième exemple de réalisation du rotateur de polarisation n'assure pas d'isolation optique.

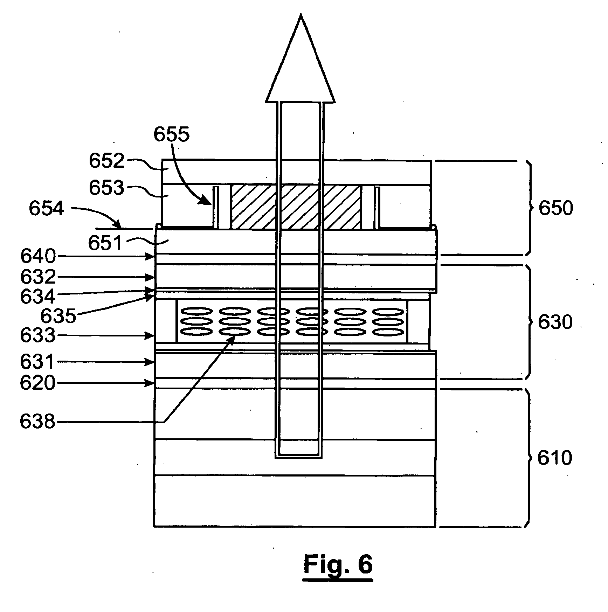

La Fig. 6 illustre un exemple de magnétomètre à pompage optique selon l'invention, réalisé sous forme intégrée.

Ce magnétomètre utilise avantageusement une diode laser à cavité verticale émettant par la surface (VCSEL), 610, sur laquelle on dispose successivement la première lame quart d'onde, 620, la cellule à cristal liquide 630, la seconde lame quart d'onde, 640, et la cellule de gaz, 650.

La cellule à cristal liquide est prise en sandwich entre la première et la seconde lames quart d'onde. Elle est délimitée verticalement par une première lame de verre 631 et une seconde lame de verre 632, et latéralement par une entretoise (par ex. cylindrique), 633, en polymère. La cavité ainsi délimitée est remplie d'un cristal liquide nématique. La couche de cristal liquide nématique fait quelques microns d'épaisseur. Une couche conductrice transparente à la longueur d'onde du laser (typiquement en ITO), 634, est déposée sur la surface supérieure de la première lame de verre et sur la surface inférieure de la seconde lame de verre de manière à pouvoir appliquer une tension électrique à la cellule 630. Une couche d'alignement, 635, par exemple en polyimide est prévue sur les couches conductrices transparentes haute et basse de manière à aligner au repos le cristal liquide.

La cellule de gaz, 650, est délimitée verticalement par une troisième lame de verre 651 et une quatrième lame de verre 652, et latéralement par une entretoise en silicium 653. La cavité ainsi délimitée est remplie par exemple d'hélium $^4$He ou d'un gaz alcalin. Des fils conducteurs 654 reliés au circuit de décharge HF sont prévus pour alimenter des électrodes 655 (situées dans des vias du silicium ou sur la tranche de la cellule) diamétralement opposées deux à deux par rapport à l'axe de la cavité.

Enfin deux bobines orthogonales, réalisées sous la forme d'éléments discrets (non représentés), sont disposées autour de la cavité pour générer le champ magnétique RF.

On comprendra que la structure du magnétomètre est particulièrement compacte et peu susceptible de désalignement ou de déformation mécanique.

En pratique, les matériaux utilisés (couches ITO, couche polyimide) ont une signature magnétique négligeable.

La signature du rotateur de polarisation est essentiellement due au champ magnétique créé par le signal de commande de la cellule à cristal liquide. En effet, afin d'éliminer la migration d'impuretés vers les parois de la cellule de cristal liquide, le signal de commande est alternatif et de fréquence de l'ordre de 100Hz à 10 kHz (l'amplitude efficace du signal commande la rotation de polarisation) et l'intensité maximale du courant de déplacement est de l'ordre d'une dizaine de $\mu$A.

Compte tenu des ordres de grandeurs présentés ci-dessus, la signature du signal de commande de la cellule de cristal liquide est inférieure à une dizaine de $p$T et donc parfaitement négligeable vis-à-vis de $B_0$.

L'intégration du magnétomètre rend sa fabrication compatible avec une réalisation en nombre, ce qui permet d'en réduire les coûts de fabrication au moyen de techniques classiques de micro-fabrication de la micro-électronique.

Le magnétomètre décrit ci-dessus est un magnétomètre scalaire au sens où, comme on l'a dit, il ne permet de mesurer que le module $B_0$ du champ magnétique ambiant $\mathbf{B_0}$. Il est toutefois possible de construire un magnétomètre vectoriel à partir de ce magnétomètre scalaire, comme décrit dans la demande européenne EP-A-964260. Ce magnétomètre vectoriel comprend un enroulement conducteur supplémentaire, autrement dit, en tout, trois enroulements conducteurs entourant la cellule et dont les axes forment un trièdre rectangle, chaque enroulement étant excité avec un signal de fréquence distincte, soit $F_x$ pour l'axe Ox, $F_y$ selon l'axe Oy et $F_z$ selon l'axe Oz, les courants dans les trois bobines étant contrôlés à l'aide de moyens d'asservissement. Le principe de la mesure est identique à celui donné dans la demande précitée.

**Revendications**

1. Magnétomètre à pompage optique comprenant une cellule (10) remplie d'un gaz, une source laser (14) émettant un faisceau lumineux, un photodétecteur (24) recevant le faisceau ayant traversé la cellule et fournissant un signal électrique, une première et une seconde bobines d'axes orthogonaux ($56_1$, $56_2$) entourant la cellule et alimentées par un générateur radiofréquence (22) pour y générer un champ magnétique radiofréquence ($\mathbf{B_{RF}}$), des premiers moyens d'asservissement (20) recevant ledit signal électrique et adaptés à asservir la fréquence ($F$) du générateur radiofréquence à la fréquence de Larmor, des seconds moyens d'asservissement (40) adaptés à maintenir la direction de polarisation $\mathbf{(P)}$ du faisceau en entrée de la cellule orthogonale au champ magnétique à mesurer ($\mathbf{B_0}$), des troisièmes moyens d'asservissement (50) adaptés à maintenir la direction du champ radiofréquence $\mathbf{(B_{RF})}$ identique à la direction de polarisation, **caractérisé en ce qu'**il comprend un rotateur de polarisation à cristal liquide recevant le faisceau lumineux et adapté à en faire tourner la direction de polarisation, ledit rotateur de polarisation étant commandé par un signal de commande fourni par les seconds moyens d'asservissement (40).

2. Magnétomètre à pompage optique selon la revendication 1, **caractérisé en ce que** les troisièmes moyens d'asservissement reçoivent ledit signal de commande, en déduisent un couple de coefficients trigonométriques donnant la position angulaire ($\varphi$) de ladite direction de polarisation et alimentent les premières et secondes bobines avec des courants à la fréquence du générateur radiofréquence et d'amplitudes respectives proportionnelles aux dits coefficients.

3. Magnétomètre à pompage optique selon la revendication 2, **caractérisé en ce que** lesdits coefficients trigonométriques sont fournis par une mémoire contenant des courbes de calibration de l'angle de rotation du rotateur en fonction dudit signal de commande pour une pluralité de températures de fonctionnement.

4. Magnétomètre à pompage optique selon l'une des revendications précédentes, **caractérisé en ce que** les seconds moyens d'asservissement effectuent une détection synchrone du signal électrique à la fréquence du générateur radiofréquence et génère le signal de commande à partir de la composante en quadrature $\left( LA_1^Q \right)$ dudit signal électrique à cette fréquence.

5. Magnétomètre à pompage optique selon la revendication 4, **caractérisé en ce que** le signal de commande est validé au moyen d'une porte logique par un signal de validation, préalablement à son application au rotateur de polarisation, ledit signal de validation étant obtenu par comparaison entre un indicateur et une valeur de seuil prédéterminée ($Th$), ledit indicateur étant choisi parmi le module de la composante continue ($LA_0$) du signal électrique et le module de la composante ($LA_2$) de ce même signal à une fréquence double de la fréquence du générateur de fréquence.

6. Magnétomètre à pompage optique selon l'une des revendications précédentes, **caractérisé en ce que** le rotateur de polarisation comprend :

    - une première lame quart d'onde (310) et une seconde lame quart d'onde (330), l'axe lent de la première lame quart d'onde coïncidant avec l'axe rapide de la seconde lame quart d'onde et l'axe rapide de la première lame quart d'onde coïncidant avec l'axe lent de la seconde lame quart d'onde ;
    - une lame à retard variable (320) située entre les première et seconde lames quart d'onde et constituée d'une cellule à cristal liquide dont la bissectrice entre ses axes neutres coïncide avec un axe neutre de la première lame quart d'onde et un axe neutre de la seconde lame quart d'onde.

7. Magnétomètre à pompage optique selon l'une des revendications 1 à 5, **caractérisé en ce que** le rotateur de polarisation comprend :

    - une première lame quart d'onde (310) et une seconde lame quart d'onde (330), l'axe lent de la première lame quart d'onde coïncidant avec l'axe rapide de la seconde lame quart d'onde et l'axe rapide de la première lame quart d'onde coïncidant avec l'axe lent de la seconde lame quart d'onde ;

- une lame à retard variable (320) située entre les première et seconde lames quart d'onde et constituée d'une cellule à cristal liquide ;

- un polariseur (305) en amont de la première lame quart d'onde (310) dans le sens de propagation dudit faisceau, le polariseur polarisant ledit faisceau selon une direction bissectrice des axes neutres de la première lame quart d'onde.

8. Magnétomètre à pompage optique selon l'une des revendications 1 à 5, **caractérisé en ce que** le rotateur de polarisation le long d'un axe optique commun :

- un premier bloc optique (301) comprenant un polariseur rectiligne (305) et une première lame quart d'onde (310), d'orientation fixe l'un par rapport l'autre, la direction de polarisation dudit polariseur étant bissectrice des axes neutres de la lame quart d'onde ;

- un second bloc optique (302) comprenant une lame à retard variable (320) constituée par une lame à cristal liquide, et une seconde lame quart d'onde (330), d'orientation fixe l'une par rapport à l'autre, les axes neutres de la seconde lame quart d'onde étant bissecteurs des axes neutres de la lame à retard variable.

9. Magnétomètre à pompage optique selon la revendication 8, **caractérisé en ce que** l'orientation relative des premier et second blocs optiques autour de l'axe optique commun est réglable, et réglée de sorte que les axes lent et rapide de la première lame quart d'onde coïncident respectivement avec les axes rapide et lent de la seconde lame quart d'onde.

10. Magnétomètre à pompage optique selon l'une des revendications 1 à 5, **caractérisé en ce que** le rotateur de polarisation comprend :

- une lame quart d'onde ayant des axes neutres ;

- une lame à retard variable située en amont de la lame quart d'onde dans la direction de propagation du faisceau, constituée d'une cellule à cristal liquide, et dont la bissectrice entre ses axes neutres coïncide avec un axe neutre de la lame quart d'onde, le faisceau en entrée du rotateur de polarisation étant polarisé selon une direction bissectrice des axes neutres de la lame à retard variable.

11. Magnétomètre selon l'une des revendications précédentes, **caractérisé en ce qu'**il est réalisé de manière intégrée, le laser étant une diode laser à cavité verticale émettant par la surface, le rotateur de polarisation étant disposé directement sur ladite surface de la diode laser, et la cellule remplie de gaz étant disposée sur la face de sortie du rotateur de polarisation.

12. Magnétomètre selon les revendications 6 et 11, **caractérisé en ce que** la première lame quart d'onde est disposée sur ladite surface de la diode laser et que la cellule remplie de gaz est disposée sur la seconde lame quart d'onde, la cellule à cristal liquide étant prise en sandwich entre la première et la seconde lames quart d'onde.

**Patentansprüche**

1. Optisch gepumptes Magnetometer, umfassend eine mit einem Gas gefüllte Zelle (10), eine einen Lichtstrahl emittierende Laserquelle (14), einen Fotodetektor (24), der den Strahl empfängt, welcher die Zelle durchquert hat, und ein elektrisches Signal liefert, eine erste und eine zweite Spule mit orthogonalen Achsen ($56_1$, $56_2$), die die Zelle umgeben und von einem Radiofrequenzgenerator (22) gespeist werden, um dort ein magnetisches Radiofrequenzfeld ($B_{RF}$) zu erzeugen, erste Regelmittel (20), die das elektrische Signal empfangen und dazu ausgelegt sind, die Frequenz (F) des Radiofrequenzgenerators auf die Larmorfrequenz zu regeln, zweite Regelmittel (40), die dazu ausgelegt sind, die Polarisationsrichtung (P) des Strahls am Eingang der Zelle orthogonal zu dem zu messenden Magnetfeld ($B_0$) zu halten, dritte Regelmittel (50), die dazu ausgelegt sind, die Richtung des Radiofrequenzfelds ($B_{RF}$) identisch zur Polarisationsrichtung zu halten, **dadurch gekennzeichnet, dass** es eine Flüssigkristall-Polarisationsdrehvorrichtung umfasst, die den Lichtstrahl empfängt und dazu ausgelegt ist, seine Polarisationsrichtung zu drehen, wobei die Polarisationsdrehvorrichtung durch ein Steuersignal gesteuert wird, das von den zweiten Regelmitteln (40) geliefert wird.

2. Optisch gepumptes Magnetometer nach Anspruch 1, **dadurch gekennzeichnet, dass** die dritten Regelmittel das Steuersignal empfangen, hieraus ein Paar von trigonometrischen Koeffizienten ableiten, die die Winkelposition ($\varphi$) der Polarisationsrichtung angeben, und die erste und die zweite Spule mit Strömen bei der Frequenz des Radiofrequenzgenerators und mit jeweiligen Amplituden proportional zu den Koeffizienten versorgen.

3. Optisch gepumptes Magnetometer nach Anspruch 2, **dadurch gekennzeichnet, dass** die trigonometrischen Koeffizienten von einem Speicher geliefert werden, der Kalibrierungskurven des Drehwinkels der Drehvorrichtung als Funktion des Steuersignals für eine Mehrzahl von Arbeitstemperaturen enthält.

**4.** Optisch gepumptes Magnetometer nach einem der vorhergehenden Ansprüche, **dadurch gekennzeichnet, dass** die zweiten Regelmittel eine Synchronerfassung des elektrischen Signals bei der Frequenz des Radiofrequenzgenerators ausführen und das Steuersignal ausgehend von der Quadraturkomponente $\left(LA_1^Q\right)$ des elektrischen Signals bei dieser Frequenz erzeugen.

**5.** Optisch gepumptes Magnetometer nach Anspruch 4, **dadurch gekennzeichnet, dass** das Steuersignal mit Hilfe eines logischen Gatters durch ein Validierungssignal vor seinem Anlegen an die Polarisationsdrehvorrichtung validiert wird, wobei das Validierungssignal erhalten wird durch Vergleich zwischen einem Indikator und einem vorbestimmten Schwellenwert ($Th$), wobei der Indikator ausgewählt ist aus dem Betrag der konstanten Komponente ($LA_0$) des elektrischen Signals und dem Betrag der Komponente ($LA_2$) dieses gleichen Signals mit einer Frequenz, die das Doppelte der Frequenz des Frequenzgenerators ist.

**6.** Optisch gepumptes Magnetometer nach einem der vorhergehenden Ansprüche, **dadurch gekennzeichnet, dass** die Polarisationsdrehvorrichtung umfasst:

    - ein erstes Viertelwellenplättchen (310) und ein zweites Viertelwellenplättchen (330), wobei die langsame Achse des ersten Viertelwellenplättchens mit der schnellen Achse des zweiten Viertelwellenplättchens zusammenfällt, und die schnelle Achse des ersten Viertelwellenplättchens mit der langsamen Achse des zweiten Viertelwellenplättchens zusammenfällt;
    - ein Plättchen mit variabler Verzögerung (320), das zwischen dem ersten und dem zweiten Viertelwellenplättchen angeordnet und aus einer Flüssigkristallzelle gebildet ist, bei dem die Winkelhalbierende zwischen seinen neutralen Achsen mit einer neutralen Achse des ersten Viertelwellenplättchens und einer neutralen Achse des zweiten Viertelwellenplättchens zusammenfällt.

**7.** Optisch gepumptes Magnetometer nach einem der Ansprüche 1 bis 5, **dadurch gekennzeichnet, dass** die Polarisationsdrehvorrichtung umfasst:

    - ein erstes Viertelwellenplättchen (310) und ein zweites Viertelwellenplättchen (330), wobei die langsame Achse des ersten Viertelwellenplättchens mit der schnellen Achse des zweiten Viertelwellenplättchens zusammenfällt und die schnelle Achse des ersten Viertelwellenplättchens mit der langsamen Achse des zweiten Viertelwellenplättchens zusammenfällt;
    - ein Plättchen mit variabler Verzögerung (320), das zwischen dem ersten und dem zweiten Viertelwellenplättchen angeordnet und aus einer Flüssigkristallzelle gebildet ist;
    - einen Polarisator (305) stromaufwärts des ersten Viertelwellenplättchens (310) in der Ausbreitungsrichtung des Strahls, wobei der Polarisator den Strahl entlang einer Richtung polarisiert, die die Winkelhalbierende der neutralen Achsen des ersten Viertelwellenplättchens ist.

**8.** Optisch gepumptes Magnetometer nach einem der Ansprüche 1 bis 5, **dadurch gekennzeichnet, dass** die Polarisationsdrehvorrichtung entlang einer optischen Achse umfasst:

    - einen ersten optischen Block (301), umfassend eine linearen Polarisator (305) und ein erstes Viertelwellenplättchen (310) mit einer relativ zueinander festen Orientierung, wobei die Polarisationsrichtung des Polarisators eine Winkelhalbierende der neutralen Achsen des Viertelwellenplättchens ist;
    - einen zweiten optischen Block (302), umfassend ein Plättchen mit variabler Verzögerung (320), das durch ein Flüssigkristallplättchen gebildet ist, sowie ein zweites Viertelwellenplättchen (330) mit einer relativ zueinander festen Orientierung, wobei die neutralen Achsen des zweiten Viertelwellenplättchens Winkelhalbierende der neutralen Achsen des Plättchens mit variabler Verzögerung sind.

**9.** Optisch gepumptes Magnetometer nach Anspruch 8, **dadurch gekennzeichnet, dass** die Relativorientierung des ersten und des zweiten optischen Blocks um die gemeinsame optische Achse herum einstellbar ist und derart eingestellt ist, dass die langsame und die schnelle Achse des ersten Viertelwellenplättchens mit der schnellen bzw. der langsamen Achse des zweiten Viertelwellenplättchens zusammenfallen.

**10.** Optisch gepumptes Magnetometer nach einem der Ansprüche 1 bis 5, **dadurch gekennzeichnet, dass** die Polarisationsdrehvorrichtung umfasst:

    - ein Viertelwellenplättchen mit neutralen Achsen;
    - ein Plättchen mit variabler Verzögerung, das stromaufwärts des Viertelwellenplättchens in der Ausbreitungsrichtung des Strahls angeordnet und durch eine Flüssigkristallzelle gebildet ist, und bei dem die Winkelhalbierende zwischen seinen neutralen Achsen mit einer neutralen Achse des Viertelwellenplättchens zusammenfällt, wobei der Strahl am Eingang der Polarisationsdrehvorrichtung in einer Richtung polarisiert wird, die eine Winkelhalbierende der neutralen Achsen des Plättchens mit variabler Verzögerung ist.

11. Magnetometer nach einem der vorhergehenden Ansprüche, **dadurch gekennzeichnet, dass** es in integrierter Weise ausgeführt ist, wobei der Laser eine Laserdiode mit vertikaler Kavität ist, die durch die Oberfläche emittiert, wobei die Polarisationsdrehvorrichtung direkt auf der Oberfläche der Laserdiode angeordnet ist, und wobei die mit Gas gefüllte Zelle auf der Ausgangsfläche der Polarisationsdrehvorrichtung angeordnet ist.

12. Magnetometer nach den Ansprüchen 6 und 11, **dadurch gekennzeichnet, dass** das erste Viertelwellenplättchen auf der Oberfläche der Laserdiode angeordnet ist, und dass die mit Gas gefüllte Zelle auf dem zweiten Viertelwellenplättchen angeordnet ist, wobei die Flüssigkristallzelle sandwichförmig zwischen dem ersten und dem zweiten Viertelwellenplättchen eingefügt ist.

**Claims**

1. An optical pumping magnetometer comprising a cell (10) filled with a gas, a laser source (14) emitting a light beam, a photodetector (24) receiving the beam that passed through the cell and providing an electric signal, a first and a second coils (56$_1$, 56$_2$) having orthogonal axes, surrounding the cell and fed by a radiofrequency generator (2) to generate a radiofrequency magnetic field (**B$_{RF}$**) therein, first regulating means (20) receiving said electric signal and suitable for regulating the frequency (*F*) of the radiofrequency generator to the Larmor frequency, second regulating means (40) suitable for keeping the direction of polarization (**P**) of the beam at the inlet of the cell orthogonal to the magnetic field to be measured (**B$_0$**), third regulating means (50) suitable for keeping the direction of the radiofrequency field (**B$_{RF}$**) identical to the direction of polarization, **characterised in that** it comprises a liquid crystal polarization rotator receiving the light beam and suitable for rotating the direction of polarization thereof, said polarization rotator being controlled by a control signal provided by the second regulating means (40).

2. The optical pumping magnetometer according to claim 1, **characterised in that** the third regulating means receive said control signal, deduce therefrom a couple of trigonometric coefficients giving the angular position (φ) of said direction of polarization and feed the first and second coils with currents at the frequency of the radiofrequency generator and having respective amplitudes proportional to said coefficients.

3. The optical pumping magnetometer according to claim 2, **characterised in that** said trigonometric coefficients are provided by a memory containing calibration curves of the angle of rotation of the rotator as a function of said control signal for a plurality of operating temperatures.

4. The optical pumping magnetometer according to one of the preceding claims, **characterised in that** the second regulating means perform a synchronous detection of the electric signal at the frequency of the radiofrequency generator and generates the control signal from the quadrature component $\left( LA_1^Q \right)$ of said electric signal at this frequency.

5. The optical pumping magnetometer according to claim 4, **characterised in that** the control signal is enabled by means of a logic gate by an enable signal, before it is applied to the polarization rotator, said enable signal being obtained by a comparison between an indicator and a predetermined threshold value (*Th*), said indicator being selected from the module of the DC component (*LA$_0$*) of the electric signal and the module of the component (*LA$_2$*) of the same signal at a frequency twice the frequency of the frequency generator.

6. The optical pumping magnetometer according to one of the preceding claims, **characterised in that** the polarization rotator comprising:

   - a first quarter wave plate (310) and a second quarter wave plate (330), the slow axis of the first quarter wave plate being coextensive with the fast axis of the second quarter wave plate and the fast axis of the first quarter wave plate being coextensive with the slow axis of the second quarter wave plate;
   - a variable delay plate (320) located between the first and second quarter wave plates and consisting of a liquid crystal cell the bisectrix of which between its neutral axes is coextensive with a neutral axis of the first quarter wave plate and a neutral axis of the second quarter wave plate.

7. The optical pumping magnetometer according to one of claims 1 to 5, **characterised in that** the polarization rotator comprises:

   - a first quarter wave plate (310) and a second quarter wave plate (330), the slow axis of the first quarter wave plate being coextensive with the fast axis of the second quarter wave plate and the fast axis of the first quarter wave plate being coextensive with the slow axis of the second quarter wave plate;
- a variable delay plate (320) located between the first and second quarter wave plates and consisting of a liquid crystal cell;
- a polarizer (305) upstream of the first quarter wave plate (310) in the direction of propagation of said beam, the polarizer polarizing said beam along a direction being a bisectrix of the neutral axes of the first quarter wave plate.

8. The optical pumping magnetometer according to one of claims 1 to 5, **characterised in that** the polarization rotator along a common optical axis:

- a first optical block (301) comprising a rectilinear polarizer (305) and a first quarter wave plate (310), having a fixed orientation with respect to each other, the direction of polarization of said polarizer being a bisectrix of the neutral axes of the quarter wave plate;
- a second optical block (302) comprising a variable delay plate (320) consisting of a liquid crystal plate, and a second quarter wave plate (330), having a fixed orientation with respect to each other, the neutral axes of the second quarter wave plate being bisectrix of the neutral axes of the variable delay plate.

9. The optical pumping magnetometer according to claim 8, **characterised in that** the relative orientation of the first and second optical blocks about the common optical axis is adjustable, and adjusted such that the slow and rapid axes of the first quarter wave plate are respectively coextensive with the fast and slow axes of the second quarter wave plate.

10. The optical pumping magnetometer according to one of claims 1 to 5, **characterised in that** the polarization rotator comprises:

- a quarter wave plate having neutral axes;
- a variable delay plate located upstream of the quarter wave plate in the direction of propagation of the beam, consisting of a liquid crystal cell, and the bisectrix of which between its neutral axes is coextensive with a neutral axis of the quarter wave plate, the beam at the inlet of the polarization rotator being polarized along a bisecting direction of the neutral axes of the variable delay plate.

11. The magnetometer according to one of the preceding claims, **characterised in that** it is made in an integrated way, the laser being a vertical cavity laser diode emitting through the surface, the polarization rotator being directly provided on said surface of the laser diode, and the gas filled cell being provided on the outlet face of the polarization rotator.

12. The magnetometer according to claims 6 and 11, **characterised in that** the first quarter wave plate is provided on said surface of the laser diode and that the gas filled cell is provided on the second quarter wave plate, the liquid crystal cell is sandwiched between the first and second quarter wave plates.

**Fig. 1**

**Fig. 2**

Fig. 3A

**Fig. 3B**

EP 2 795 354 B1

**Fig. 3C**

**Fig. 4**

Fig. 5

**Fig. 6**

## RÉFÉRENCES CITÉES DANS LA DESCRIPTION

**Documents brevets cités dans la description**

- EP 579537 A

- EP 964260 A